(19) Europäisches Patentamt
European Patent Office
Office européen des brevets

(11) **EP 1 616 355 B1**

(12) **EUROPÄISCHE PATENTSCHRIFT**

(45) Veröffentlichungstag und Bekanntmachung des Hinweises auf die Patenterteilung:
**09.07.2008 Patentblatt 2008/28**

(51) Int Cl.:
*H01L 29/417* (2006.01)      *H01L 29/08* (2006.01)
*H01L 29/732* (2006.01)

(21) Anmeldenummer: **04721910.0**

(86) Internationale Anmeldenummer:
**PCT/EP2004/050335**

(22) Anmeldetag: **19.03.2004**

(87) Internationale Veröffentlichungsnummer:
**WO 2004/095584 (04.11.2004 Gazette 2004/45)**

(54) **BIPOLARTRANSISTOR UND VERFAHREN ZUR HERSTELLUNG DESSELBEN**

BIPOLAR TRANSISTOR AND METHOD FOR THE PRODUCTION THEREOF

TRANSISTOR BIPOLAIRE ET PROCEDE DE FABRICATION DUDIT TRANSISTOR

(84) Benannte Vertragsstaaten:
**DE FR GB**

(30) Priorität: **23.04.2003 DE 10318422**

(43) Veröffentlichungstag der Anmeldung:
**18.01.2006 Patentblatt 2006/03**

(73) Patentinhaber: **Infineon Technologies AG**
**81669 München (DE)**

(72) Erfinder:
• **BÖCK, Josef**
**81827 München (DE)**
• **MEISTER, Thomas**
**82024 Taufkirchen (DE)**
• **STENGL, Reinhard**
**86391 Stadtbergen (DE)**
• **SCHÄFER, Herbert**
**85635 Höhenkirchen-Siegertsbrunn (DE)**

(74) Vertreter: **Karl, Frank et al**
**Kindermann Patentanwälte**
**Postfach 100234**
**85593 Baldham (DE)**

(56) Entgegenhaltungen:
**US-A- 5 596 221          US-A1- 2002 149 062**

• **KONDO M ET AL: "VARIATION IN EMITTER DIFFUSION DEPTH BY TISI2 FORMATION ON POLYSILICON EMITTERS OF SI BIPOLAR TRANSISTORS" IEEE TRANSACTIONS ON ELECTRON DEVICES, IEEE INC. NEW YORK, US, Bd. 48, Nr. 9, September 2001 (2001-09), Seiten 2108-2117, XP001082164 ISSN: 0018-9383**
• **CHIH-FANG HUANG ET AL: "4H-SiC npn bipolar junction transistors with BVceo > 39200 V" PROCEEDINGS OF THE 14TH. INTERNATIONAL SYMPOSIUM ON POWER SEMICONDUCTOR DEVICES & ICS. ISPSD'02. SANTA FE, NM, JUNE 4 - 7, 2002, INTERNATIONAL SYMPOSIUM ON POWER SEMICONDUCTOR DEVICES & IC'S, NEW YORK, NY : IEEE, US, 4. Juni 2002 (2002-06-04), Seiten 57-60, XP010591565 ISBN: 0-7803-7318-9**

**Beschreibung**

Die Erfindung betrifft einen Hochfrequenz-Bipolartransistor bestehend aus zumindest einem Emitterkontakt, der an einen Emitteranschlussbereich angrenzt, einem Basiskontakt, der an einen Basisanschlussbereich angrenzt, einem Kollektorkontakt, der an einen Kollekotoranschlussbereich angrenzt, wobei als Kollektoranschlussbereich eine vergrabene Schicht vorgesehen ist, die den Kollektorkontakt mit dem Kollektorgebiet verbindet. Solch ein Hochfrequenz-Bipolartransistor ist aus der US 5,773,350 bekannt.

Die Erfindung betrifft weiterhin ein Verfahren zur Herstellung eines Hochfrequenz-Bipolartransistors, bei dem ein Kollektoranschlussbereich, ein Kollektorgebiet, zumindest auf dem Kollektoranschlussbereich eine erste Isolationsschicht, ein Basisgebiet, ein Basisanschlussbereich, zumindest auf dem Basisanschlussbereich eine zweite Isolationsschicht und ein Emitteranschlussbereich zur Verfügung gestellt werden, wobei der Kollektoranschlussbereich als vergrabene Schicht ausgeführt wird. Solch ein Verfahren ist aus der DE 19958062 bekannt.

Für einen Bipolartransistor gilt nachfolgende Gleichung,

$$\frac{1}{2\pi f_T} \approx \tau_f + (R_C + R_E)C_{BC} + \frac{C_{BE} + C_{BC}}{I_C}U_T$$

mit der Transitfrequenz $f_T$, der Transitzeit $\hat{o}_f$, dem Kollektorwiderstand $R_C$, dem Emitterwiderstand $R_E$, der Basis-Kollektor-Kapazität $C_{BC}$, der Basis-Emitter-Kapazität $C_{BE}$, dem Kollektorstrom $I_C$ und der Thermospannung $U_T$.

Mit zunehmendem Kollektorstrom $I_C$ wird der Term proportional $1/I_C$ immer kleiner. Der Hauptanteil der Transitfrequenz $f_T$ ist daher neben der Transitzeit $\hat{o}_f$ insbesondere durch den Kollektorwiderstand $R_C$ und den Emitterwiderstand $R_E$ gegeben. Bei heutigen Transistoren ist die Transitfrequenz $f_T$, neben der Transitzeit $\hat{o}_f$, jedoch hauptsächlich durch den Kollektorwiderstand $R_C$ gegeben, der typischerweise eine Größenordnung größer ist als der Emitterwiderstand $R_E$. Für schnelle Transistoren muss daher der Kollektorwiderstand minimiert werden.

Zum Erzielen eines niederohmigen Kollektoranschlusses, wird im Allgemeinen eine hochdotierte vergrabene Schicht (Buried Layer) verwendet. Diese Schicht wird zu Beginn der Transistorherstellung erzeugt. Im Anschluss wird auf diese niederohmige Schicht eine Halbleiterschicht epitaktisch aufgewachsen, in der die Emitter-, Basis-, und Kollektorgebiete erzeugt werden. Die hochdotierte vergrabene Schicht wird durch einen metallischen Kollektorkontakt angeschlossen und an die Oberfläche des Bipolartransistors geführt. Dies ist beispielsweise in der US 5,773,350 und DE 19958062 beschrieben.

In der Regel ist auf nur einer Seite des Transistors ein Kollektorkontakt vorgesehen. Wird die vergrabene Schicht nicht nur auf einer Seite angeschlossen, sondern auch auf der gegenüberliegenden Seite oder sogar ringförmig um das gesamte Transistorgebiet, können kleinere Kollektorwiderstände erzielt werden. Solche Transistorkonfigurationen weisen einen in etwa halb bzw. viertel so großen Widerstand auf, wie eine Konfiguration mit lediglich einem einzigen Kollektorkontakt, da der Kollektorstrom nicht nur nach einer Seite, sondern nach zwei bzw. vier Seiten fließen kann.

Allerdings bringt diese Ausführung wesentliche Nachteile mit sich. Zum einen vergrößern sich die Transistorabmessungen durch die zusätzlichen Kollektorkontaktgebiete. Dies führt zu höheren Herstellungskosten aufgrund der größeren benötigten Substratfläche. Zum anderen wird auch die Kollektor-Substrat-Kapazität des Bipolartransistors proportional zur zunehmenden Fläche der vergrabenen Schicht vergrößert. Dies wiederum führt zu negativen Auswirkungen, wie einer höheren Gatterverzögerungszeit oder erhöhtem Leistungsverbrauch von integrierten Schaltungen.

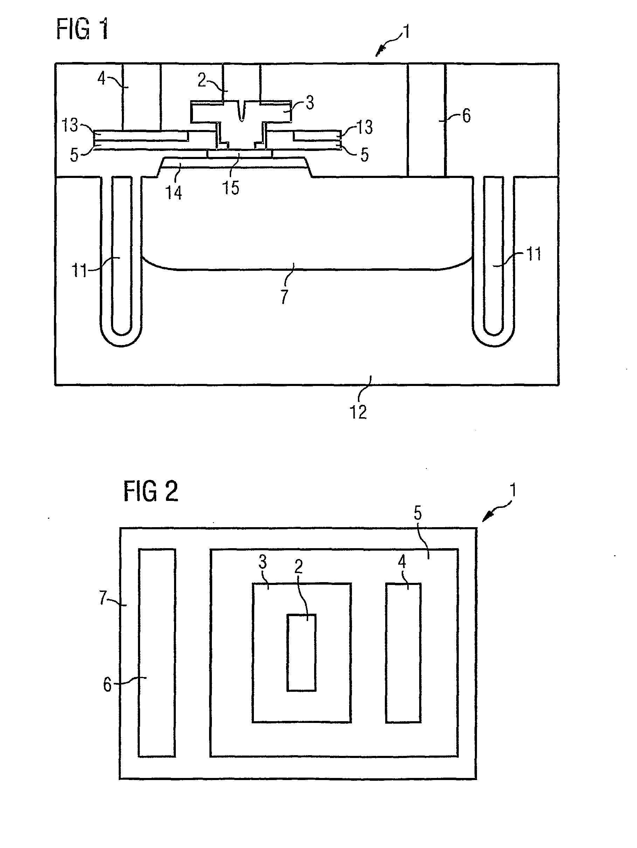

Gemäß "Variation in emitter diffusion depth by TiSi2 formation on polysilicon emitters of Si bipolar transistors", M. Kondo et al, IEEE Transactions on electron devices, vol. 48, no. 9, September 2001, pp. 2108 to 2117, Figur 1, gibt es einen Abstand größer Null zwischen dem Basisanschlussgebiet und dem Silizid auf dem Kollektor.

Gemäß US 5,596,221, Figur 14, liegt eine Abstand größer Null zwischen dem Basisanschlussgebiet und dem Silizid auf dem Kollektor vor. Gemäß US 2002/0149062, Figur 16, liegt eine Abstand größer Null zwischen dem Basisanschlussgebiet und dem Silizid auf dem Kollektor vor.

Gemäß "4H-SiC npn bipolar junction transistor with BVCE0 > 3,200 V", Huang u.a., proceedings of the 14th international symposium on power semiconductor devices &ICs, ISPSD'02, Santa Fe, NM, June 4 - 7, 2002, New York, NY: IEEE, US, 4. June 2002, pages 57 to 60, Figur 1, liegt der Basisanschlussbereich auf der einen Seite eines Siliziumplättchens und der Kollektoranschlussbereich auf der Rückseite.

Aufgabe der vorliegenden Erfindung ist demnach, einen Hochfrequenz-Bipolartransistor vorzustellen, der einen geringen Platzbedarf mit einem niedrigen Kollektorwiderstand und damit einer hohen Transitfrequenz kombiniert. Weiterhin ist es Aufgabe, ein Verfahren zur Herstellung solch eines Bipolartransistors, ohne zusätzlichen Prozessaufwand zu erreichen.

Erfindungsgemäß wird die Aufgabe durch einen Hochfrequenz-Bipolartransistor der eingangs erwähnten Art gelöst, der eine Silizidregion auf der vergrabenen Schicht aufweist, die den Kollektorkontakt niederohmig an das Kollektorgebiet anschließt , wobei die Silizidregion selbstjustiert zum Basisanschlussbereich und in Falllinie zur äußeren Grenze des Basisanschlussbereichs gebildet ist. Hierdurch wird erreicht, dass der Kollektorwiderstand reduziert wird, weil das Kollektorgebiet des Bipolartransistors quasi von allen Seiten angeschlossen wird, obwohl nur auf einer Seite ein Kollektorkontakt vorgesehen ist.

Der Erfindung liegt die Erkenntnis zugrunde, dass sich durch eine Silizidregion auf der vergrabenen Schicht, Schichtwiderstände von ca. 1 Ohm/sq erzielen lassen. Dagegen weist eine entsprechende vergrabene Schicht mit einer Dicke von einigen µm nach einer Dotierung lediglich Schichtwiderstände auf, die bei ca. 10 Ohm/sq liegen. Der Schichtwiderstand der vergrabenen Schicht und damit der Kollektoranschlusswiderstand, kann also durch eine Silizidregion bis zu etwa einer Größenordnung reduziert werden. Der Schichtwiderstand ist dann so niedrig, dass auch bei einer Kontaktierung der vergrabenen Schicht auf nur einer einzigen Transistorseite, der Kollektoranschlussbereich quasi von allen Seiten durch die Silizidregion niederohmig angeschlossen ist.

In einer typischen Ausgestaltung des erfindungsgemäßen Bipolartransistors weist die Silizidregion eine Dicke im Bereich zwischen 10 und 200 nm auf, vorzugsweise liegt die Dicke der Silizidregion bei ca. 100 nm.

Typischerweise enthält die Silizidregion zumindest ein Übergangsmetall. Als Übergangsmetall können beispielsweise Titan, Kobalt, Nickel, Platin oder Tantal eingesetzt werden, die mit Silizium ein entsprechendes Übergangssilizid bilden. Vorzugsweise wird für die Silizierung dasselbe Metall verwendet, das im Gesamtprozess zur Silizierung anderer Gebiete wie z. B. des Basisanschlussbereichs oder von Source-, Drain- und Gate-Gebieten von CMOS-Transistoren ohnehin benötigt wird. Somit kann das Übergangsmetall für die Ausbildung der Silizidregion ohne Zusatzkosten in den Transistor integriert werden.

In einer besonders vorteilhaften Ausgestaltung des erfindungsgemäßen Hochfrequenz-Bipolartransistors enthält die Silizidregion Titan oder Kobalt. Diese Übergangsmetalle gewährleisten einen besonders niedrigen Schichtwiderstand der vergrabenen Schicht. Es wird also ein Metall gewählt, das einen möglichst niedrigen Schichtwiderstand liefert.

Die Silizierung bzw. Ausbildung der Silizidregion bewirkt typischerweise eine Verringerung des Schichtwiderstandes von ca. 100 Ohm/sq einer 100 nm dicken dotierten Polysiliziumschicht auf ca. 1 Ohm/sq. Im Vergleich hierzu liegt der Schichtwiderstand einer entsprechend dicken dotierten Siliziumschicht bei ca. 10 Ohm/sq, eine Metallschicht liegt im mOhm/sq-Bereich.

Darüber hinaus wird die Aufgabe, ein Verfahren der eingangs genannten Art gelöst, indem

- die erste Isolationsschicht, zumindest teilweise, bis zur vergrabenen Schicht entfernt wird, und
- unmittelbar vor Herstellung eines Emitterkontaktes, eines Basiskontaktes und eines Kollektorkontaktes eine Silizidregion auf der vergrabenen Schicht zur Verfügung gestellt wird,

- wobei die Silizidregion derart ausgebildet wird, dass der Kollektorkontakt niederohmig an das Kollektorgebiet angeschlossen wird,

wobei die Silizidregion selbstjustiert zum Basisanschlussbereich und in Falllinie zur äußeren Grenze des Basisanschlussbereich gebildet ist.

Hierdurch kann ohne zusätzlichen Prozessaufwand ein Hochfrequenz-Bipolartransistor erzeugt werden, der sowohl einen geringen Platzbedarf als auch einen niedrigen Kollektorwiderstand und damit eine hohe Transitfrequenz kombiniert.

Im Unterschied zu bekannten Verfahren, wie dem so genannten Buried Metal-Verfahren, bei dem die vergrabene Schicht direkt nach seiner Erzeugung siliziert wird oder sogar vollständig aus Metall besteht, wird hier die vergrabene Schicht erst nach der vollständigen Fertigstellung des Bipolartransistors, unmittelbar vor Beginn der Herstellung der Kontakte (der Elektroden) siliziert. Damit vermeidet man das Aufbringen von Metall bereits während der Transistorherstellung und damit auch Metallkontaminationen, die eine solche Prozessführung inkompatibel und ungeeignet für heutige Transistorherstellverfahren machen.

Typischerweise wird die Silizidregion in einer Dicke zwischen 10 und 200 nm, vorzugsweise 100 nm, ausgebildet.

Eine andere Ausgestaltung des erfindungsgemäßen Verfahrens sieht vor, dass zur Ausbildung der Silizidregion ein Übergangsmetall verwendet wird, vorzugsweise Titan oder Kobalt. Dieses Übergangsmetall bildet mit Silizium das entsprechende Übergangsmetallsilizid. Typischerweise wird ein Übergansmetall gewählt, das einen möglichst niedrigen Schichtwiderstand der vergrabenen Schicht liefert.

In einer Weiterentwicklung des erfindungsgemäßen Verfahrens wird sowohl die erste Isolationsschicht als auch die zweite Isolationsschicht zumindest teilweise entfernt, so dass die vergrabene Schicht bzw. der Basisanschlussbereich zumindest teilweise freiliegen und siliziert werden können. Die Isolationsschichten bestehen üblicherweise aus Siliziumoxid oder Siliziumnitrid. Die Isolationsschicht lässt sich also im Falle von Siliziumnitrid mit Phosphorsäure, im Falle von Siliziumoxid mit Flusssäure entfernen. Bestehen beide Isolationsschichten aus demselben Material, bedarf es zur Ätzung keines zusätzlichen Prozessschritts. Bestehen die Isolationsschichten aus unterschiedlichen Materialien, wird nach der Ätzung der ersten Isolationsschicht das Ätzmedium zur Ätzung der zweiten Isolationsschicht gewechselt.

Nach der Ätzung sind sowohl der Basisanschlussbereich als auch die vergrabene Schicht, zumindest teilweise, freigelegt und können siliziert werden. Um während der Ätzungen ein unerwünschtes Anätzen anderer Chipbereiche z. B. von Isolationsgebieten oder anderen Bauteilen zu vermeiden, kann die Ätzung unter Zuhilfenahme einer Maske erfolgen. In den Bereichen, in denen geätzt werden soll, wird die Maske entfernt, die anderen Bereiche bleiben bedeckt.

Üblicherweise erfolgt die Ätzung aufgrund der hohen Selektivität nasschemisch. Prinzipiell können aber auch trockenchemische Ätzverfahren verwendet werden.

Eine bevorzugte Weiterbildung des erfindungsgemäßen Verfahrens sieht vor, dass die Silizidregion selbstjustiert zum Basisanschlussbereich gebildet wird. Hierbei wird lediglich auf Silizium eine Silizidregion gebildet, Bereiche wie z. B. Siliziumoxid oder -nitrid werden nicht siliziert.

Solch ein so genanntes "Salicide-Verfahren" (Salicide = selfaligned Silicide) ist beispielsweise aus der DE 19958062 bekannt.

Die Definition der Lage der Silizidregion auf der vergrabenen Schicht findet also ohne Zuhilfenahme einer Fotolithographie statt. Hierdurch kann die Silizidregion relativ klein gehalten werden, beispielsweise im Bereich zwischen 0,25 bis 0,35 $\mu$m.

Bevorzugte Ausführungsbeispiele der vorliegenden Erfindung werden nachfolgend bezugnehmend auf die beiliegenden Zeichnungen im Detail erläutert. Es zeigen

Fig. 1: In schematischer Querschnittsansicht einen bekannten Bipolartransistor.

Fig. 2: In schematischer Aufsicht einen bekannten Bipolartransistor, bei dem die vergrabene Schicht auf einer Seite mit einem Kollektorkontakt versehen ist.

Fig. 3: In schematischer Aufsicht einen bekannten Bipolartransistor, bei dem die vergrabene Schicht auf zwei Seiten mit einem Kollektorkontakt versehen ist.

Fig. 4: In schematischer Aufsicht einen bekannten Bipolartransistor, bei dem die vergrabene Schicht ringförmig um den Transistor mit einem Kollektorkontakt versehen ist.

Fig. 5: In schematischer Aufsicht einen erfindungsgemäßen Bipolartransistor mit ringförmig silizierter vergrabener Schicht, selbst justiert zum Basisanschlussbereich.

Fig. 6: In schematischer Aufsicht einen erfindungsgemäßen Bipolartransistor mit teilweise silizierter vergrabenen Schicht, selbstjustiert zum Basisanschlussbereich.

Fig. 7: In schematischer Querschnittsansicht einen Bipolartransistor nach Strukturierung des Emitteranschlussbereiches.

Fig. 8: In schematischer Querschnittsansicht einen erfindungsgemäßen Bipolartransistor nach Ätzung der Isolationsschichten und nach Ausbildung einer Silizidregion.

Die Figur 1 zeigt in schematischer Querschnittsansicht einen bekannten Bipolartransistor 1, bei dem im Halbleitersubstrat 12 eine vergrabene Schicht 7 angeordnet ist, die von zwei Isolationsgebieten 11, hier als tiefe Gräben (Trenche) 11 ausgestaltet, begrenzt wird. Die vergrabene Schicht 7 ist über einen Kollektorkontakt 6 angeschlossen, der zur Oberfläche des Bipolartransistors 1 elektrisch herausgeführt wird. Hierdurch wird die Integration des Bipolartransistors 1 in einen integrierten Schaltkreis ermöglicht.

Der Bipolartransistor 1 enthält weiterhin einen Emitterkontakt 2, der an einen Emitteranschlussbereich 3 angrenzt, sowie einen Basiskontakt 4. Zur Reduzierung des Basiswiderstandes ist, wie in der Figur 1 dargestellt, auf einem Basisanschlussbereich 5 ein silizierter Basisanschlussbereich 13 vorgesehen, der den Basiskontakt 4 mit dem Basisanschlussbereich 5 verbindet. Solch ein Bipolartransistor 1 ist beispielsweise in der DE 199 58 062 beschrieben.

Das Basisgebiet 15 unterhalb des Emitteranschlussbereiches 3 kann aus Silizium-Germanium SiGe bestehen weist und eine Dicke zwischen 1 nm und 200 nm, typischerweise 30 nm auf.

Unterhalb des Basisgebietes 15 ist das Kollektorgebiet 14, angrenzend zur vergrabenen Schicht 7, angeordnet. Diese vergrabene Schicht 7 ist in der Figur 1 lediglich auf einer Seite des Bipolartransistors 1 mit einem Kollektorkontakt 6 versehen.

Die Figur 2 zeigt schematisch in einer Aufsicht einen Bipolartransistor, bei dem die vergrabene Schicht 7 auf einer einzigen Seite mit einem Kollektorkontakt 6 versehen ist. Der Basisanschlussbereich 5 wird von einem Basiskontakt 4, der Emitteranschlussbereich 3 von einem Emitterkontakt 2 angeschlossen. In solch einer Ausgestaltung hat der Bipolartransistor 1 zwar eine geringe Fläche, die durch die Ausdehnung der vergrabenen Schicht 7 bestimmt wird, jedoch ist der Kollektorbereich (hier nicht dargestellt), aufgrund des relativ großen Schichtwiderstands der vergrabenen Schicht 7 lediglich auf einer Seite durch den Kollektorkontakt 6 angeschlossen.

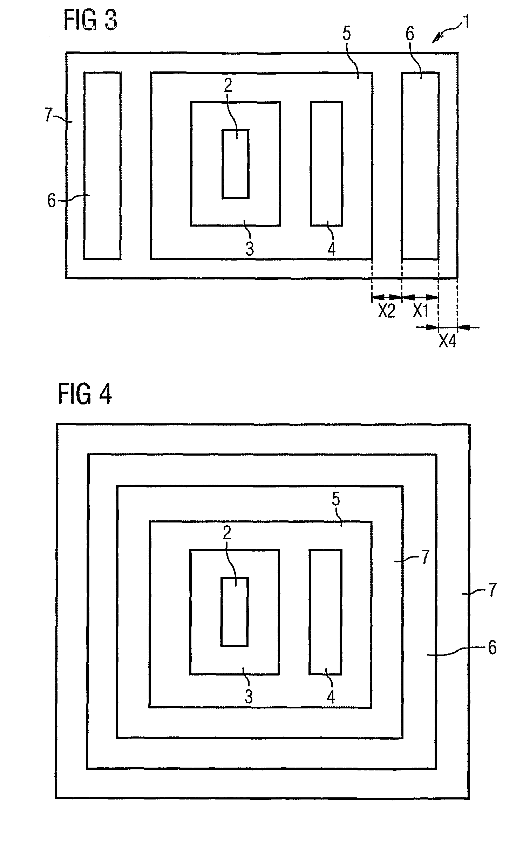

Kleinere Kollektorwiderstände können erzielt werden, indem die vergrabene Schicht 7 nicht nur auf einer Seite, wie in der Figur 2, sondern auch auf der gegenüberliegenden Seite angeschlossen werden, wie in der Figur 3 schematisch in einer Aufsicht gezeigt. Der Bipolartransistor 1 aus der Figur 3 weist einen in etwa halb so großen Widerstand auf, wie der Bipolartransistor 1 aus der Figur 2.

Allerdings wird deutlich, dass die Fläche, die die vergrabene Schicht 7 einnimmt, größer ist, als die vergrabene Schicht 7 des Bipolartransistors aus der Figur 2. Die zusätzlich benötigte Fläche der vergrabenen Schicht 7 ergibt sich aus der Breite X1 des Kollektorkontaktes 6, dem Abstand X2 von dem Kollektorkontakt 6 zum Basisanschlussbereich 5 und einem Überstand X4 der vergrabener Schicht 7, wobei der Überstand X4 in der Figur 3, den Abstand vom Kollektorkontakt 6 zum nächstliegenden Rand der vergrabenen Schicht 7 darstellt.

Diese zusätzlich benötigte Fläche ist durch die zur Verfügung stehende Fotolithographie und Justiertoleranzen gegeben. Typische Kontaktlochbreiten bei der Fotolithographie sind heute beispielsweise 0,5 $\mu$m und Justiertoleranzen von 0,25 $\mu$m, so dass insgesamt die vergrabene Schicht 7 um ca. 1 $\mu$m verbreitert wird, wenn ein zusätzlicher Kollektorkontakt 6 angebracht wird.

Noch geringere Schichtwiderstände der vergrabenen Schicht 7 werden erzielt, wenn, wie in der Figur 4 schematisch gezeigt, der Kollektorkontakt 6 und die vergrabene Schicht 7 ringförmig um den Basisanschlussbereich 5 angebracht werden. Hier kann der Kollektorstrom nach vier Seiten fließen, wodurch sich der Kollektoranschlusswiderstand viertelt. Allerdings führen diese vergrößerten Kollektorkontakte 6 zu deutlich vergrößerten Abmessungen des Bipolartransistors 1. Neben den erhöhten Herstellungskosten aufgrund der größeren benötigten Fläche im Halbleitersubstrat wird auch die Kollektor-Substrat-Kapazität des Bipolartransistors 1 proportional zur zunehmenden Fläche der vergrabenen Schicht 7 vergrößert. Dies führt zu einer größeren Gatterverzögerungszeit des Transistors oder einem erhöhten Leistungsverbrauch von integrierten Schaltungen.

Welche Transistorkonfiguration bislang verwendet wird, hängt also davon ab, ob der Transistor für höchste Transitfrequenz, wie anhand der Figur 4, geringsten Platzbedarf, wie anhand der Figur 2, oder einen Kompromiss aus beidem, wie anhand der Figur 3 beschrieben, ausgelegt wird.

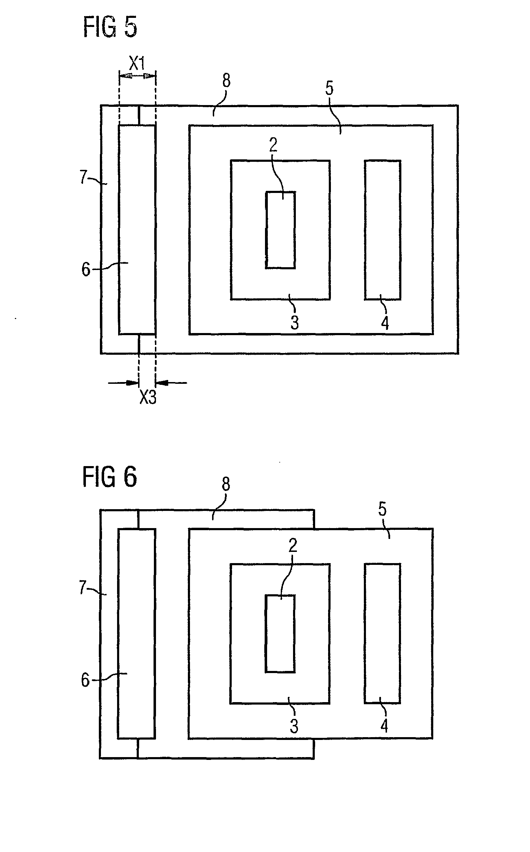

Der erfindungsgemäße Bipolartransistor 1 aus der Figur 5 vereint sowohl einen niedrigen Kollektorwiderstand und damit eine hohe Transitfrequenz als auch einen geringen Platzbedarf. Die Draufsicht zeigt, dass sich die Silizidregion 8 rund um den Basisanschlussbereich 5 erstreckt. In der Figur 5 ist die Breite X3 des Überlappungsbereiches zwischen dem Kollektorkontakt 6 und der Silizidregion 8 kleiner als die Breite X1 des Kollektorkontaktes 6.

Typischerweise sind die Breite X3 des Überlappungsbereiches und die Breite X1 des Kollektorkontaktes 6 gleich groß. Der Kollektorkontakt 6 kann also mit seinem gesamten Querschnitt die Silizidregion 8 bedekken. Der Kollektorkontakt ist auch dann mit der Silizidregion 8 verbunden, wenn Justierungenauigkeiten auftreten.

Weiterhin kann die vergrabene Schicht 7, auf der dem Basisanschlussbereich 5 abgewandten Seite des Kollektorkontaktes 6, unsiliziert bleiben, wie dies in den Figuren 5 und 6 gezeigt ist. Dies kann von Vorteil sein, wenn andere Bauelemente, die nicht siliziert werden sollen sehr nahe liegen. Eine Hilfsmaske, die die Silizierung verhindert, kann dann kleiner gewählt werden, als bei vollständiger Silizierung der vergrabenen Schicht 7, wenn sich die Silizidregion 8 also auf der gesamte Fläche der vergrabenen Schicht 7 erstreckt. Hierdurch sinkt der mögliche Minimalabstand der Bauelemente und damit die benötigte Fläche von integrierten Schaltkreisen.

Die Silizidregion 8 weist einen Schichtwiderstand im Ohmbereich auf. Der Schichtwiderstand der vergrabenen Schicht 7 ist damit derart erniedrigt, dass auch bei einer Metallkontaktierung der vergrabenen Schicht 7 mit Hilfe des Kollektorkontaktes 6 auf nur einer einzigen Seite des Bipolartransistors 1 das Kollektorgebiet effektiv von allen Seiten durch die Silizidregion 8 niedrohmig angeschlossen ist.

Es ist hierbei nicht nötig, dass die Silizidregion 8 als geschlossener Ring zum Kollektorkontakt 6 geführt wird. Eine deutliche Verringerung des Kollektorwiderstands ergibt sich bereits, wenn die vergrabene Schicht 7 beispielsweise nur bis zu den Stirnseiten des Bipolartransistors 1 siliziert wird, wie anhand der Figur 6 in einer schematischen Aufsicht gezeigt ist. Hier erstreckt sich die Silizidregion 8 zumindest bis auf Höhe des Emitterkontaktes 2.

Diese Konfiguration kann beispielsweise günstig sein, wenn, wie anhand der Figur 1 gezeigt, der Basisanschlussbereich 5 teilweise über ein Isolationsgebiet wie einen Trench geführt wird. Somit können die Transistorabmessungen so klein wie möglich gehalten werden.

Für den erfindungsgemäßen Bipolartransistor 1 ist es unwesentlich, ob die Silizidregion 8 die gesamte, nicht vom Basisanschlussbereich 5 bedeckte, vergrabene Schicht 7 bedeckt, oder Bereiche der vergrabenen Schicht 7 unsiliziert bleiben, so lange eine durchgehende Verbindung von der Silizidregion 8 zum Kollektorkontakt 6 besteht.

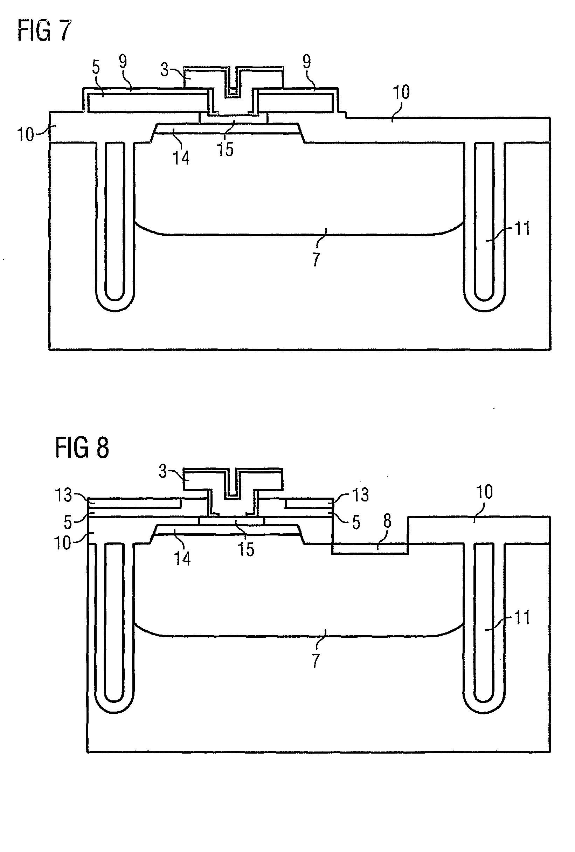

Anhand der Figuren 7 und 8 wird im Folgenden beschrieben, wie eine Silizidregion 8 selbstjustiert zum Basisanschlussbereich 5, ohne wesentlichen Zusatzaufwand im Vergleich zu bekannten Herstellungsverfahren, erzeugt wird.

Zunächst wird ein Bipolartransistor 1 in bekannter Weise hergestellt, wobei eine vergrabene Schicht 7, ein Kollektorgebiet 14, eine erste Isolationsschicht 10 auf der vergrabenen Schicht 7 und dem Kollektorgebiet 14, ein Basisgebiet 15 auf dem Kollektorgebiet 14, ein

Basisanschlussbereich 5, eine zweite Isolationsschicht 9 auf dem Basisanschlussbereich 5 und ein Emitteranschlussbereich 3 erzeugt werden. Der Emitterbereich, der an den Basisbereich 15 angrenzt ist nicht gezeigt.

Sowohl die zweite Isolationsschicht 9, als auch die erste Isolationsschicht 10, können beispielsweise aus Siliziumoxid oder Siliziumnitrid bestehen. Die erste Isolationsschicht 10 kann eine Dicke von einigen 100 nm, vorzugsweise 100 bis 600 nm, die zweite Isolationsschicht 9 eine Dicke zwischen 50 bis 300 nm aufweisen. Im Allgemeinen ist die erste Isolationsschicht 10 dicker als die zweite Isolationsschicht 9.

Die vergrabene Schicht 7 besteht typischerweise aus einer 1 bis 9 μm hochdotierten Silizium Schicht, das Kollektorgebiet 14 aus einer 100 bis 1000 nm dicken epitaktischen SiliziumSchicht und der Basisanschlussbereich 5 aus einer 50 bis 300 nm dicken hochdotierten Polysilizium-Schicht.

Solch ein bekanntes Verfahren zur Herstellung eines Bipolartransistors 1 ist beispielsweise ausführlich in der DE 199 58 062 C2 beschrieben.

Im erfindungsgemäßen Verfahren wird nun vorzugsweise, wie anhand der Figur 8 gezeigt, die erste Isolationsschicht 10 über der vergrabenen Schicht 7, im Falle von Siliziumoxid mit Flusssäure, im Falle von Siliziumnitrid mit Phosphorsäure, entfernt. Diese Ätzung findet selbstjustiert zum Basisanschlussbereich 5 statt. Um während dieser Ätzungen ein unerwünschtes Anätzen anderer Chipbereiche zu vermeiden, kann die Ätzung unter Zuhilfenahme einer Maske, die beispielsweise aus Lack sein kann, erfolgen, die Bereiche, in denen nicht geätzt werden soll, abdeckt und nur die Bereiche freigelassen werden, die in einem nachfolgenden Verfahrensschritt siliziert werden sollen.

Es ist denkbar, lediglich die erste Isolationsschicht 10 vollständig bis zur vergrabenen Schicht 7 zu entfernen, um eine Silizidregion 8 in der vergrabenen Schicht 7 herzustellen.

Für die Herstellung der Silizidregion 8 kann beispielsweise entweder ein Metall direkt aufgebracht werden (z. B. mit Hilfe von Sputtern) und die Oberfläche der vergrabenen Schicht 7 und des Metalls in Silizid umgewandelt werden oder ein Silizid direkt aufgebracht werden. Die Dicke solch einer Silizidregion 8 liegt typischerweise im Bereich zwischen 10 und 200 nm.

Soll neben der vergrabenen Schicht 7 zusätzlich auch der Basisanschlussbereich 5 siliziert werden, wird die zweite Isolationsschicht 9 ebenfalls entfernt. Besteht die zweite Isolationsschicht 9 und die erste Isolationsschicht 10 aus demselben Material, so ist es üblicherweise hierzu nicht einmal nötig, die Ätzzeit zu verlängern, da meist die erste Isolationsschicht 10 dicker als die zweite Isolationsschicht 9 ist. Bestehen die Isolationsschichten 9 und 10 aus unterschiedlichen Materialien, wird nach der Ätzung der zweiten Isolationsschicht 9 das Ätzmedium zum Entfernen der ersten Isolationsschicht 10 gewechselt.

Sowohl die zweite Isolationsschicht 9 als auch die erste Isolationsschicht 10 können jeweils aus verschiedenen Schichten aufgebaut sein. Die Ätzungen sind dann derart auszuführen, dass zumindest alle Schichten dieser Isolationsschichten 9 und 10 entfernt werden.

Das oben beschriebene Verfahren bewirkt, dass die vergrabene Schicht 7 selbstjustiert zum Basisanschlussbereich 5 siliziert wird. Die Silizidregion 8 auf der vergrabenen Schicht 7 ist hierdurch in Falllinie zur äußeren Grenze des Basisanschlussbereichs 5 angeordnet, d.h. die Silizidregion 8 grenzt in einer Aufsicht, wie aus den Figuren 5 und 6 ersichtlich, direkt an den Basisanschlussbereich 5. Hierdurch sind besonders kleine Abmessungen des Bipolartransistors 1 möglich, die kleiner sind, als über Fotolithographie hergestellt. Weitere Vorteile einer Selbstjustierung liegen im symmetrischen Aufbau des Bipolartransistors 1. Darüber hinaus fallen geringere Kosten an, als bei justierten Verfahren, da keine Lithographie nötig ist.

Im Anschluss wird der Bipolartransistor 1 in der üblichen Weise fertig gestellt, d. h. es wird ein Dielektrikum abgeschieden, das den gesamten Bipolartransistor 1 bedeckt. Anschließend werden Metallkontakte, der Emitterkontakt, der Basiskontakt und der Kollektorkontakt, erzeugt und Metallisierungsebenen abgeschieden.

Das oben beschriebene Verfahren lässt sich sowohl für selbstjustierte Doppelpolysiliziumtransistoren, d. h. solche Transistoren bei denen der Emitter- und Basisanschlussbereich jeweils aus Polysilizium bestehen und zueinander selbstjustiert sind, als auch für Polytransistoren oder justierte Transistoren anwenden.

Insgesamt wird durch die Erfindung erreicht, dass ein Hochfrequenz-Bipolartransistor zur Verfügung gestellt wird, der sowohl geringen Platzbedarf und dadurch geringeren Leistungsverbrauch, als auch einen niedrigen Kollektorwiderstand und damit eine hohe Transitfrequenz miteinander kombiniert. Darüber hinaus wurde ein erfindungsgemäßes Verfahren vorgestellt, das die Herstellung einen Hochfrequenz-Bipolartransistors mit den oben genannten Eigenschaften, ohne zusätzlichen Prozessaufwand ermöglicht.

Der erfindungsgemäße Hochfrequenz-Bipolartransistor weist, im Vergleich zu bekannten Bipolartransistoren mit gleichem Platzbedarf, einen geringeren Kollektorwiderstand und damit eine bessere Transistorleistung, wie eine höhere Transitfrequenz, geringere Gatterverzögerungszeiten, oder einen geringeren Leistungsverbrauch von integrierten Schaltkreisen auf. Hierbei sind die Herstellungskosten vergleichbar.

Im Vergleich zu bekannten Hochfrequenz-Bipolartransistoren mit ringförmig angeschlossenem Kollektor, zeigt der erfindungsgemäße Hochfrequenz-Bipolartransistor ähnlich schnelle Transitfrequenzen, jedoch bei deutlich geringeren Herstellungskosten aufgrund des geringeren Platzbedarfs, und geringeren Leistungsverbrauch, aufgrund der kleineren Kollektor-Substrat-Kapazität.

**Patentansprüche**

1. Hochfrequenz-Bipolartransistor (1) bestehend aus zumindest

    - einem Emitterkontakt (2), der an einen Emitteranschlussbereich (3) angrenzt,
    - einem Basiskontakt (4), der an einen Basisanschlussbereich (5) angrenzt,
    - einem Kollektorkontakt (6), der an einen Kollektoranschlussbereich (7) angrenzt, wobei als Kollektoranschlussbereich eine vergrabene Schicht (7) vorgesehen ist, die den Kollektorkontakt (6) mit einem Kollektorgebiet (14) verbindet,

wobei eine Silizidregion (8) auf der vergrabenen Schicht (7) vorgesehen ist, die den Kollektorkontakt (6) niederohmig an

das Kollektorgebiet (14) anschließt,
**dadurch gekennzeichnet,**
**dass** die Silizidregion (8) selbstjustiert zum Basisanschlussbereich (5) und in Falllinie zur äußeren Grenze des Basisanschlussbereichs gebildet ist.

2. Bipolartransistor nach Anspruch 1
**dadurch gekennzeichnet,**
**dass** die Silizidregion (8) eine Dicke im Bereich zwischen 10 und 200 nm aufweist.

3. Bipolartransistor nach einem der Ansprüche 1 bis 2
**dadurch gekennzeichnet ,**
**dass** die Silizidregion (8) zumindest ein Übergangsmetall enthält.

4. Verfahren zur Herstellung eines Hochfrequenz-Bipolartransistors (1), bei dem

- ein Kollektoranschlussbereich (7),
- ein Kollektorgebiet (14),
- zumindest auf dem Kollektoranschlussbereich (7) eine erste Isolationsschicht (10),
- ein Basisgebiet (15)
- ein Basisanschlussbereich (5),
- zumindest auf dem Basisanschlussbereich (5) eine zweite Isolationsschicht (9) und
- ein Emitteranschlussbereich (3) zur Verfügung gestellt werden,
- wobei der Kollektoranschlussbereich als vergrabene Schicht (7) ausgeführt wird,
- wobei die erste Isolationsschicht (10), zumindest teilweise, bis zur vergrabenen Schicht(7) entfernt wird und
- wobei unmittelbar vor Herstellung eines Emitterkontaktes (2), eines Basiskontaktes (4) und eines Kollektorkontaktes (6) eine Silizidregion (8) auf der vergrabenen Schicht (7) zur Verfügung gestellt wird,
- wobei die Silizidregion (8) derart ausgebildet wird, dass der Kollektorkontakt (6) niederohmig an das Kollektorgebiet (14) angeschlossen wird,

**dadurch gekennzeichnet,**
**dass** die Silizidregion (8) selbstjustiert zum Basisanschlussbereich (5) und in Falllinie zur äußeren Grenze des Basisanschlussbereichs gebildet wird.

5. Verfahren nach Anspruch 4,

**dadurch gekennzeichnet,**
**dass** die Silizidregion (8) in einer Dicke zwischen 10 und 200 nm ausgebildet wird.

6. Verfahren nach einem der Ansprüche 4 bis 5,
**dadurch gekennzeichnet ,**
**dass** zur Ausbildung der Silizidregion (8) ein Übergangsmetall verwendet wird.

7. Verfahren nach einem der Ansprüche 4 bis 6,
**dadurch gekennzeichnet,**
**dass** sowohl die zweite Isolationsschicht (9) als auch die erste Isolationsschicht (10), zumindest teilweise, entfernt werden.

**Claims**

1. High-frequency bipolar transistor (1) comprising at least

    - an emitter contact (2) adjoining an emitter connection region (3),
    - a base contact (4) adjoining a base connection region (5),
    - a collector contact (6) adjoining a collector connection region (7), a buried layer (7) being provided as the collector connection region, said buried layer connecting the collector contact (6) to a collector zone (14),

a silicide region (8) being provided on the buried layer (7), said silicide region connecting the collector contact (6) to the collector zone (14) in a low-impedance manner,
**characterized**
**in that** the silicide region (8) is formed in a self-aligned manner with respect to the base connection region (5) and on a gradient aligned with respect to the outer boundary of the base connection region.

2. Bipolar transistor according to Claim 1,
**characterized**
**in that** the silicide region (8) has a thickness in the range of between 10 and 200 nm.

3. Bipolar transistor according to either of Claims 1 and 2,
**characterized**
**in that** the silicide region (8) contains at least one transition metal.

4. Method for the production of a high-frequency bipolar transistor (1), in which

    - a collector connection region (7),
    - a collector zone (14),
    - at least on the collector connection region (7) a first insulation layer (10),

- a base zone (15),

- a base connection region (5),

- at least on the base connection region (5) a second insulation layer (9) and

- an emitter connection region (3) are made available,

- the collector connection region being embodied as a buried layer (7),

- the first insulation layer (10) being removed, at least partly, as far as the buried layer (7), and

- directly before the production of an emitter contact (2), of a base contact (4) and of a collector contact (6), a silicide region (8) being made available on the buried layer (7),

- the silicide region (8) being formed in such a way that the collector contact (6) is connected to the collector zone (14) in a low-impedance manner,

**characterized**
**in that** the silicide region (8) is formed in a self-aligned manner with respect to the base connection region (5) and on a gradient aligned with respect to the outer boundary of the base connection region.

**5.** Method according to Claim 4,
**characterized**
**in that** the silicide region (8) is formed with a thickness of between 10 and 200 nm.

**6.** Method according to either of Claims 4 and 5,
**characterized**
**in that** a transition metal is used for forming the silicide region (8).

**7.** Method according to one of Claims 4 to 6,
**characterized**
**in that** both the second insulation layer (9) and the first insulation layer (10) are removed, at least partly.

**Revendications**

**1.** Transistor ( 1 ) bipolaire de haute fréquence constitué d'au moins

- un contact ( 2 ) d'émetteur, qui touche une partie ( 3 ) de borne d'émetteur,
- un contact ( 4 ) de base, qui touche une partie ( 5 ) de borne de base,
- un contact ( 6 ) de collecteur, qui touche une partie ( 7 ) de borne de collecteur, une couche ( 7 ) enfouie qui relie le contact ( 6 ) de collecteur à une zone ( 14 ) de collecteur étant prévue en tant que partie de borne de collecteur,

dans lequel il est prévu une région ( 8 ) de siliciure sur la couche ( 7 ) enfouie, qui raccorde le contact ( 6 ) de collecteur à petite valeur ohmique à la zone ( 14 ) de collecteur,
**caractérisé**
**en ce que** la région ( 8 ) de siliciure est formée en étant auto-alignée avec la partie ( 5 ) de borne de base et dans la ligne de plus grande pente par rapport à la limite extérieure de la partie de borne de base.

**2.** Transistor bipolaire suivant la revendication 1,
**caractérisé**
**en ce que** la région ( 8 ) de siliciure a une épaisseur dans l'intervalle compris entre 10 et 200 nm.

**3.** Transistor bipolaire suivant l'une des revendications 1 à 2,
**caractérisé**
**en ce que** la région ( 8 ) de siliciure contient au moins un métal de transition.

**4.** Procédé de production d'un transistor ( 1 ) bipolaire de haute fréquence, dans lequel on met à disposition

- une partie ( 7 ) de borne de collecteur,
- une zone ( 14 ) de collecteur,
- au moins une première couche ( 10 ) isolante sur la partie ( 7 ) de borne de collecteur,
- une zone ( 15 ) de base,
- une partie ( 5 ) de borne de base,
- au moins une deuxième couche ( 9 ) isolante sur la partie ( 5 ) de borne de base et
- une partie ( 3 ) de borne d'émetteur,
- dans lequel on réalise la partie de borne de collecteur sous la forme d'une couche ( 7 ) enfouie,
- dans lequel on élimine la première couche ( 10 ) isolante au moins en partie jusqu'à la couche ( 7 ) enfouie et
- dans lequel, juste avant la production d'un contact ( 2 ) d'émetteur, d'un contact ( 4 ) de base et d'un contact ( 6 ) de collecteur, on met à disposition une région ( 8 ) de siliciure sur la couche ( 7 ) enfouie,
- dans lequel , on constitue la région ( 8 ) de siliciure de façon à ce que le contact ( 6 ) de collecteurs soit raccordé à petite valeur ohmique à la zone ( 14 ) de collecteur,

**caractérisé**
**en ce que** l'on forme la région ( 8 ) de siliciure à auto-alignement avec la partie ( 5 ) de borne de base et dans la ligne de plus grande pente par rapport à la limite extérieure de la partie de connexion de base.

**5.** Procédé suivant la revendication 4,
**caractérisé**
**en ce que** la région ( 8 ) de siliciure a une épaisseur comprise entre 10 et 200 nm.

6. Procédé suivant l'une des revendications 4 à 5, **caractérisé en ce que** pour former la région ( 8 ) de siliciure on utilise un métal de transition.

7. Procédé suivant l'une des revendications 4 à 6, **caractérisé en ce qu'**on élimine au moins en partie tant la deuxième couche ( 9 ) isolante qu'également la première couche ( 10 ) isolante.

## FIG 1

## FIG 2

FIG 3

FIG 4

FIG 5

FIG 6

FIG 7

FIG 8

**IN DER BESCHREIBUNG AUFGEFÜHRTE DOKUMENTE**

**In der Beschreibung aufgeführte Patentdokumente**

- US 5773350 A
- DE 19958062
- US 5596221 A
- US 20020149062 A
- DE 19958062 C2

**In der Beschreibung aufgeführte Nicht-Patentliteratur**

- **M. KONDO et al.** Variation in emitter diffusion depth by TiSi2 formation on polysilicon emitters of Si bipolar transistors. *IEEE Transactions on electron devices,* September 2001, vol. 48 (9), 2108-2117
- **HUANG U.A.** 4H-SiC npn bipolar junction transistor with BVCE0 > 3,200 V. *proceedings of the 14th international symposium on power semiconductor devices &ICs, ISPSD'02,* 04. Juni 2002, 57-60